(19) <span>Europäisches Patentamt</span>
<span>European Patent Office</span>
<span>Office européen des brevets</span>

(11) **EP 3 077 835 B1**

(12) **EUROPEAN PATENT SPECIFICATION**

(45) Date of publication and mention
of the grant of the patent:
**20.11.2019 Bulletin 2019/47**

(51) Int Cl.:
**G01R 31/12** *(2006.01)* **E21B 47/00** *(2012.01)*
**E21B 47/10** *(2012.01)* **G01M 3/00** *(2006.01)*
**G01N 27/22** *(2006.01)*

(21) Application number: **13799585.8**

(22) Date of filing: **05.12.2013**

(86) International application number:
**PCT/EP2013/075664**

(87) International publication number:
**WO 2015/082007 (11.06.2015 Gazette 2015/23)**

(54) **MEASUREMENTS IN A SUBSEA INSTALLATION**

MESSUNGEN IN EINER UNTERWASSERANLAGE

MESURES DANS UNE INSTALLATION SOUS-MARINE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**12.10.2016 Bulletin 2016/41**

(73) Proprietor: **ABB Schweiz AG**
**5400 Baden (CH)**

(72) Inventors:
• **SPINDLER, Christian**
**CH-8707 Uetikon am See (CH)**

• **DROFENIK, Uwe**
**CH-8053 Zurich (CH)**
• **KRAMER, Axel**
**CH-5430 Wettingen (CH)**

(74) Representative: **Kransell & Wennborg KB**
**P.O. Box 27834**
**115 93 Stockholm (SE)**

(56) References cited:
**CN-A- 101 763 942      GB-A- 748 462**
**JP-A- S5 883 279        US-A- 3 967 196**
**US-A1- 2007 227 880     US-A1- 2009 322 557**
**US-A1- 2011 018 733**

EP 3 077 835 B1

**Description**

FIELD OF INVENTION

The present invention generally relates to subsea installations. More particularly the present invention relates to a method of detecting conditions of electric or electronic subsea equipment, a measurement device for electric subsea equipment provided in an enclosure with an insulating medium as well as to a subsea installation comprising such a measurement device.

BACKGROUND

There is at times interest to place electric equipment on the sea bed, for instance for providing power for equipment used in oil and gas production.
In this case electric or electronic equipment, such as transformers, frequency converters, AC/DC converters etc. may be placed in an enclosure on the sea bed, which enclosure also comprises an electrical insulating medium, such as transformer oil.
It may in these situations be of interest to measure the properties of the insulating medium, for instance in order to make sure that it is not polluted by such things as water, hydraulic fluids, acids and particles. The insulating medium may also be degraded because of humidity and pressure.
It may thus be of interest to measure the quality of the insulating medium.
US 2007/0227880 discloses a testing arrangement for testing the dielectric strength of liquid insulating media. The arrangement has a test cell comprising an interior space for receiving the insulating medium to be tested and a first test electrode and a second test electrode for generating an electric field in a test volume of the test cell. The test cell is arranged in the interior of a receiving vessel which is filled with an auxiliary insulating medium or in the interior of an evacuated receiving vessel.
Another way in which this may be done is described in US 2011/0018733. This document describes the use of a bridge circuit in a subsea control module for detecting sea water and hydraulic fluid in the subsea control module. In order to perform the detection of the properties several electrode arrays provided all over the enclosure are used.
It would for instance be of interest to use a more economical approach in the provision of the measurement device.
There is thus room for improvement in the provisioning of a measurement arrangement.

SUMMARY OF THE INVENTION

One object of the present invention is to provide a compact and economical measurement device for electric subsea equipment.
This object is according to a first aspect of the present invention achieved through a measurement device for electric or electronic subsea equipment provided in an enclosure with an insulating medium, the measurement device comprising
a circuit board with a hole to be filled with the insulating medium, the hole having a rim and a first and a second opposed spaced apart capacitor electrode forming a measurement impedance for measuring changes in the dielectric properties of the insulating medium.
The invention is also concerned with a subsea installation comprising electric or electronic equipment in an enclosure filled with an insulating medium, where the subsea installation comprises a measurement device according to the first aspect.
The invention is furthermore related to a method for detecting conditions of electric or electronic subsea equipment provided in an enclosure with an insulating medium, the method being performed using a measurement device comprising a circuit board with a hole filled with the insulating medium, the hole having a rim and a first and a second opposed spaced apart capacitor electrode, the method comprising
obtaining a measurement signal reflecting impedance changes of a measurement impedance formed by the capacitor electrodes, and
providing the measurement signal to signal evaluation circuitry for evaluating the health of the electric or electronic subsea equipment, where the evaluation of the health comprises an evaluation of the dielectric properties of the insulating medium caused by impedance changes.
The present invention has a number of advantages. Since it is provided on a circuit board, it is compact and may therefore easily be fitted in the enclosure. A circuit board is furthermore often already provided for the electric equipment, why the device can be obtained in an economical way. The measurement device can also be provided with a limited number of components, which improves the economy and also makes the device more reliable.

## BRIEF DESCRIPTION OF THE DRAWINGS

The present invention will in the following be described with reference being made to the accompanying drawings, where

fig. 1 schematically shows subsea equipment connected to electric equipment on land,
fig. 2 schematically shows one piece of electric or electronic subsea equipment in an enclosure with an insulating medium,
fig. 3 schematically shows a view from above of a circuit board for at least part of the electric subsea equipment which circuit board is provided with a hole and on which capacitors are placed for forming a measurement device,
fig. 4 shows an alternative circuit board configuration,
fig. 5 shows a sectional view of a part of the circuit board around the hole,
fig. 6 shows cross sections of two electrical wires of the measurement device,
fig. 7 shows an electrical circuit diagram of the measurement device,
fig. 8 shows a sectional view of a part of the circuit board around the hole for illustrating vibrational measurements,
fig. 9A-E show various measurement signals,
fig. 10 shows a flow chart with a number of method steps in a method for detecting conditions of the electric or electronic equipment,
fig. 11 shows a sectional view of a part of the circuit board around the hole in a variation of the circuit board, and
fig. 12A-B shows two different circuit solutions that may be used for obtaining a drive voltage for the measurement device.

## DETAILED DESCRIPTION OF THE INVENTION

In the following, a detailed description of preferred embodiments of a device according to the present invention will be given.
The present invention is directed towards providing a measurement device for subsea equipment.

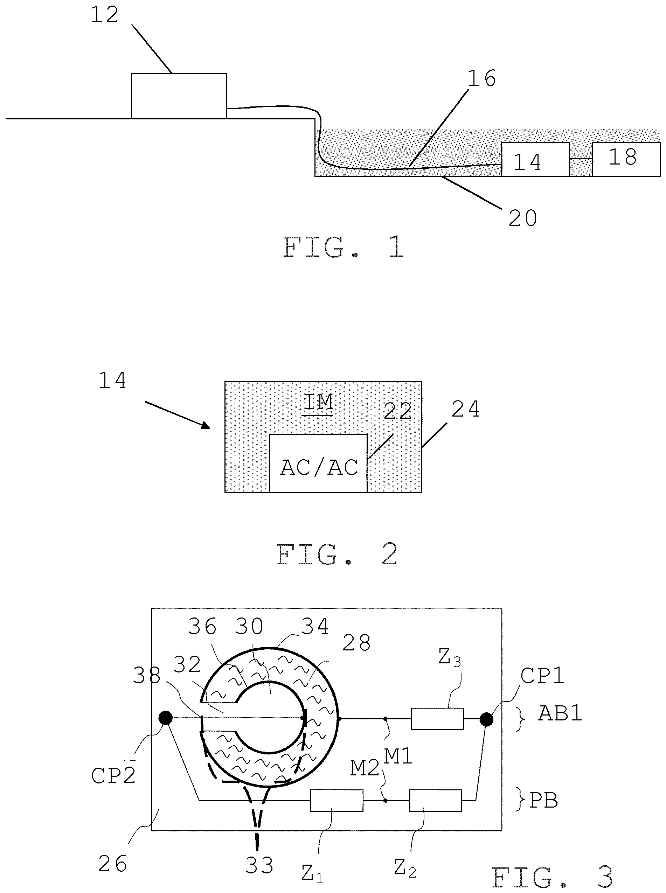

Figure 1 shows a land installation 12 connected to an electric installation 14 on a sea bed 20 via a long power supply line 16. The electric installation is also connected to a load 18, which load 18 is also placed on the sea bed 20. The load may be a motor driving a compressor or some other type of equipment for use in subsea applications such as oil and gas exploration.
The land installation 12 is thus provided on land and connected to a first end of the long power supply line 16, which is typically an alternating current (AC) cable 16, where a second end of the cable 16 is connected to the electric installation 14. It should be realized that as an alternative the cable could be a direct current (DC) cable.
The land installation 12 may be connected to an AC power network or grid and convert the power of the grid to a medium voltage (MV) level and supply to the AC line 16, the AC line 16 may in turn supply MV AC power to the installation 14, which in turn converts the frequency of the AC line voltage to a frequency suitable for operating the load 18, which load may comprise a compressor or some other piece of equipment at the seabed being operated by the electric equipment in the installation 14. The electric equipment in the installation 14 is thus electric subsea equipment.
It should be realized that the electric installation 14 is not necessarily connected to a land installation for being supplied with power. It may alternatively be connected to for instance a generator on a floating or fixed platform or a ship.
As can be seen in fig. 2, there is a piece of electric or electronic equipment 22 in the electric installation 14. The electric equipment 22 is furthermore enclosed in an enclosure 24 filled with an insulating medium IM. The insulating medium may be a fluid, such as a gas or a liquid. The electric equipment may comprise such things as a transformer, a converter, a motor drive etc. In this example it is a frequency converter, i.e. it is a converter converting between AC and AC while also changing the frequency. If the cable is a DC cable then the converter may be converting between AC and DC. It should however be realized that the electric or electronic equipment may be any type of equipment set to operate on the sea bed. It does however typically comprise semiconducting elements, such as transistors like Insulated Gate Bipolar transistors (IGBTs) or thyristors. There may also be capacitors, for instance Direct Current (DC) link capacitors between two converter sections of the AC/AC converter. The electric equipment 22 is more particularly provided on at least one circuit board, sometimes referred to as a printed circuit board (PCB) or a printed circuit board assembly (PCBA).
As will be demonstrated in the following, the circuit board will be used for providing a measurement device for performing measurements in the enclosure 24.
A plan view from above of such a circuit board 26 together with components in the form of impedances $Z_1$, $Z_2$ and $Z_3$ is shown in fig 3. The circuit board 26 comprises a hole 28, which is intended to be filled with the insulating medium IM. The hole 28 may be vertical, i. e. stretch through the board from an upper board surface to a lower board surface, where at least the upper board surface may be designed for having components mounted thereon.

The impedances on the circuit board 26 comprise a first and a second impedance $Z_1$ and $Z_2$ connected in series in a passive branch PB, between a first connection point CP1 and a second connection point CP2. The impedances also comprise a third impedance $Z_3$ connected between the second connection point CP2 and a rim of the hole 28 in the circuit board 26. In some variations of the invention the impedances are all capacitors.

The hole 28 is in the present example shaped as a partial annulus. The hole 28 has a rim and may thus be considered to be shaped as a ring with an inner and an outer radius. The hole can also be considered as having an outer circular section with a generally circular shape with an outer radius that partially encircles and defines a circular center element 30, which circular center element 30 is coaxial with the circular section defining the hole and provides an inner circular section with an inner radius. This circular center element 30 is on one side attached to the perimeter of the outer circular section. The center element 30 furthermore joins the rim of the hole via bridging section 32. The circular center element 30 and bridging section 32 together form a cantilever or projecting member 33 that projects out from a part of the rim towards the center of the hole 28. The projecting member 33 can also be seen as a peninsula of the hole. The projecting member may thus have at least one section with a curvature, here the circular center element 30, and the opposing part of the rim have the same type of curvature.

The inner circular section of the hole 28, i.e. the circular center element 30 of the projecting member 33, is provided with a first capacitive element or capacitor electrode 36. The outer circular section of the hole is provided with an opposing second capacitive element or capacitor electrode 34. As the capacitor electrodes are on different sides of the hole, they are thus spaced apart by the hole. The first capacitor electrode 36 is thus provided on the projecting member 33, while the second capacitive electrode 34 is provided on a part of the rim of the hole opposite of the first capacitor electrode 36. As can be seen in fig. 3, the inner and outer circular sections of the hole may be co-located. They may thus be coaxial and aligned with each other. Therefore the distance between the inner and outer circular sections and the capacitor electrodes may be constant and consequently also always the same in the radial direction of the circular sections.

Furthermore the first capacitor electrode 36 is galvanically connected to the first connection point CP1 via a conductor 38 and the second capacitor electrode is provided at the rim or edge of the hole and galvanically connected to the previously mentioned third impedance $Z_3$.

The two capacitor electrodes 36 and 34 together form a measurement impedance $Z_x$, which measurement impedance is thus a capacitive impedance. They may also be considered to form a first capacitive sensor. Thereby it can be seen that the first active branch AB1 comprises a series-connection of the measurement impedance $Z_x$ of the first capacitive sensor and the third impedance $Z_3$. It can thereby be seen that two branches, the first active branch AB1 and the passive branch PB, are connected in parallel between the first and second connection points CP1 and CP2.

The junction between the third and measurement impedances $Z_3$ and $Z_x$, which is a midpoint of the first active branch AB1, furthermore forms a first measurement point M1, while the junction between the first and second impedances $Z_1$ and $Z_2$, which is a midpoint of the passive branch PB, forms a second measurement point M2. Between the points M1 and M2 it is possible to measure a voltage $V_m$ using for instance a voltmeter. It is likewise possible to apply a voltage $V_G$ between the first and second connection points CP1 and CP2.

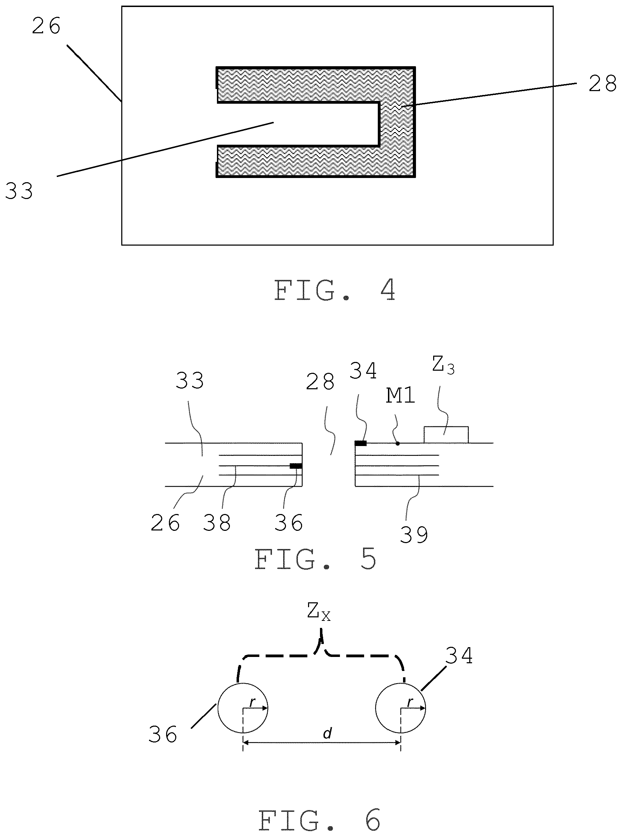

The shape of the hole in the circuit board in fig, 3 is a preferred shape. There are no edges in the capacitor electrodes, which is of advantage if used for measurements. However, it should be realized that the invention is not limited to this particular shape. It is for instance possible to use the shape of fig. 4, where the circuit board 26 has a bar shaped projecting member 33 projecting into a hole 28 shaped as a rectangle.

These are just two possible variations of the shape of the hole. Countless other shapes are possible.

Fig. 5 shows a sectional view through a part of a circuit board where the hole 28 is provided. It can be seen that the third impedance $Z_3$ is provided on an outer top surface of the board, where the second capacitor electrode 34 is located at the top outer edge of the hole 28 and is in galvanic contact with the third impedance $Z_3$. It can also be seen that the board has an interior comprising several conductors, where the first capacitor electrode 36 is provided on the opposite side of the hole from the second capacitor electrode 34 and is connected to one of inner conductors 38, which inner conductor 38 thus leads to the first connection point (not shown). This placing of the first capacitor electrode 36 is merely exemplifying. It could as an alternative be connected to another inner conductor. It could also be connected to a conductor on the outer surface of the circuit board. It should also be realized that the second capacitor electrode 34 could be connected to a conductor in the interior of the circuit board, such as the inner conductor 39. However, the capacitor electrodes are placed on opposite sides of the hole.

The capacitor electrodes are in the disclosed example provided in the form of conductive wires. Fig. 6 schematically shows the cross-section of the two such wires making up the capacitor electrodes 34 and 36 for forming the measurement impedance $Z_x$. As can be seen in fig. 6, each wire has a radius r and these two wires are provided at a distance d from each other. It should be realized that a wire is just one way of providing a capacitive element or capacitor electrode. A capacitor electrode may for instance also be provided in the form of a plate.

The circuit board with the first active branch and the passive branch provides a first measurement circuit, which in an embodiment is a Wheatstone bridge.

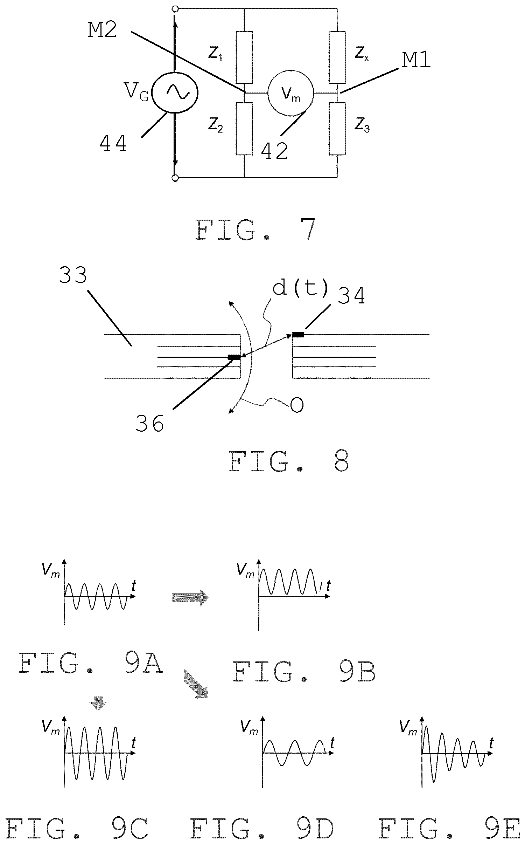

Fig. 7 schematically shows the circuit diagram of a Wheatstone bridge formed in this way. Here a measurement unit 42 in the form of voltmeter is connected between the first and second measurement points M1 and M2 for measuring a voltage $V_m$. There is also a voltage source 44 connected between the two connection points CP1 and CP2 for applying a drive voltage $V_G$ to the measurement device. A Wheatstone bridge is a well-known type of measurement circuit and needs no further description. However, it is possible to use other measurement circuits than Wheatstone bridges. In its simplest form the first measurement circuit may only comprise the measurement impedance and a detector detecting the impedance changes of this measurement impedance.

Now one function of the measurement device is going to be described in more detail.

The electric equipment 22 will be placed in the enclosure 24, which may be provided as a tank filled with insulating medium IM. The insulating medium IM may be a dielectric liquid, such as transformer oil, mineral oil, an oil containing silicon or silicone or a liquid ester. However, it may also be a gas such as SF6. The enclosure 24 may furthermore be pressurized to the ambient pressure at the sea bed.

- Many components of the electric equipment rely on high-quality insulating medium and have low tolerance against pollution in the medium or even gas bubbles in the enclosure.

- However, due to the projected long lifetime of subsea installations, and due to the high electric fields and high local temperatures present in e.g. subsea converters, it cannot be excluded that the insulating medium degrades over time and pollution or gas accumulates in the insulating medium.

- Thus, the knowledge of the state of the insulating medium is a valuable asset for safe operation and to schedule maintenance.

- There is therefore a need for obtaining a reliable and robust detection of low-level pollution in the insulating medium under subsea conditions.

- The measurement device provided through the first measurement circuit provides a solution to the above mentioned problems.

Through the measurement device the capacitance of the measurement impedance $Z_x$ may be measured. This impedance has a dependency on the insulating medium. Any changes of the impedance will then reflect changes in the dielectric properties of the insulating medium, which changes in dielectric properties may be directly indicative of conditions such as pollution or liquid decomposition. These changes can thus be measured with accuracy using the Wheatstone bridge and thereafter analyzed.

The Wheatstone bridge circuit allows to measure the unknown impedance $Z_x$ if the impedances $Z_1$, $Z_2$ and $Z_3$ are precisely known stable capacitors and the voltage $V_m$ is measured. The real impedance $Z_x$ of the capacitive sensor is then

$$Z_x = \frac{1}{\omega C}, \omega = 2\pi f$$

$$(1)$$

The Wheatstone bridge acts as a voltage divider between the two impedances in each branch. If the ratio between the two impedances in one branch matches exactly the ratio between the two impedances in the other branch, the measured voltage $V_m$=0. Any change in capacitance of the capacitive impedance changes the impedance ratio in the active branch and provokes a voltage $V_m \neq 0$.

This means that if there is a change in the measured voltage $V_m$, then the capacitance of the measurement impedance $Z_x$ is changed. This change may then be caused by a change in the dielectric properties of the insulating medium, which in turn is indicative of pollution and/or liquid decomposition.

The advantage of using a Wheatstone bridge for detecting a capacitance change is its high accuracy due to the difference measurement. Further, in the basic setup only a limited number of components are required, which leads to high part-count reliability.

The voltage measured over the bridge is:

$$V_m = \left(\frac{Z_x}{Z_x + Z_3} - \frac{Z_1}{Z_1 + Z_2}\right)V_S = \left(\frac{1}{1 + Z_3/Z_x} - \frac{Z_1}{Z_1 + Z_2}\right)V_S \qquad (2)$$

As discussed above, the capacitor electrodes or capacitor electrodes may be formed from thin copper traces running in parallel at a distance d apart. A good approximation is to regard the capacitor geometry as two parallel wires The capacitance of the measurement impedance $Z_x$ is

$$C = \frac{\pi \varepsilon l}{\ln d/r} \qquad (3)$$

where r is the radius of each wire, 1 is the length of the wires and $\varepsilon$ is the permittivity of the dielectric between the wires. After using this capacitance in (equation 1) and inserting into (equation 2), assuming that $Z_3$ is a capacitor, it is possible to obtain:

$$\frac{\partial V_m}{\partial \varepsilon} = \frac{V_S Z_3 \omega \pi l/\ln(d/r)}{(1 + Z_3 \varepsilon \omega \pi l/\ln(d/r))^2} \qquad (4)$$

When studying equation 4 it can be seen that it identifies levers that may be used optimize the geometry for improved sensitivity to changes in $\varepsilon$. It can be seen that if $\partial V_m/\partial \varepsilon$ is maximized, then the sensitivity is improved.
One way to improve the sensitivity is through maximizing $V_S$. Another way is through minimizing $Z_3$. It is also possible to minimize *l*, maximize d or minimize *r*.
A realistic geometry may exhibit the following values:

| $\varepsilon$ | $V_s[V]$ | $Z_3[\Omega]$ | w [$2\pi$ Hz] | l [m] | d [m] | r[m] | **dV/d$\varepsilon$ [V]** |
|---|---|---|---|---|---|---|---|
| 8.854E-12 * 2.2 | 100 | 10E+6 | 1.00E+03 | 3.53E-02 | 5.00E-03 | 5.00E-04 | **48E+9** |

Thus, with

$$\Delta V_m = \frac{\partial V_m}{\partial \varepsilon} \Delta \varepsilon \qquad (5)$$

$$\Delta V_m = \varepsilon_0 \cdot \frac{\partial V_m}{\partial \varepsilon_r} \Delta \varepsilon_r \qquad (6)$$

a change of $\Delta \varepsilon_r$=0.1 as observed after short aging of the insulating medium may then lead to a measurable voltage of $V_m$=42mV, given the sensor was calibrated to $V_m = 0$ in case of fresh dielectric liquid.
It can thus be seen that the measurement device allows a precise determination to be made of the changes of the permittivity of the insulating medium, i.e. of the changes of the dielectric properties. From these changes it is then possible to determine a degradation of the insulating medium.
It can in this way be seen that it is possible to measure the impurity of the insulating medium using the measurement device.
However, through the projecting member it is additionally possible to use the measurement device also for measuring vibrations. This may be of advantage in some situations, for instance in order to detect changes in a vibrational pattern of the electric installation or electric or electronic equipment 22 that could provide an indication or hint about mechanical problems.
These measurements are possible to make because of the projecting member. The projecting member may for this reason be designed to be sensitive to or to resonate at the frequencies at which vibrations occur. This is typically done through selecting the dimensions of the projecting member accordingly. Typically the length and/or the width may be set to correspond to at least a part of a wavelength of such a vibration. The vibration may in turn be a vibration at at least one a harmonic frequency of the operational frequency of the electric equipment. If the electric equipment operates at 50 Hz, then it is possible that the projecting member is dimensioned for resonance at for instance 500 HZ or even 1 kHz. The electric equipment may thus vibrate and the measurement device may, because of the projecting member then also be used for also measuring vibrations. Changes in the vibrational pattern may then be used to detect various conditions in the electric installation.

The detecting of vibrations is schematically shown in fig. 8, which shows the same type of view of a part of the circuit board as in fig. 5. Because of the vibrations of the electric equipment, the projecting member 33 may thus vibrate, which is schematically indicated in fig. 8 through a bidirectional curved shaped arrow. Because of these vibrations the distance between the two capacitor electrodes 34 and 58 will vary. This distance will thus have a dependency of time, which may be expressed as d(t).

The projecting member 33 will thus oscillate O due to the vibration. During oscillation, the wire distance d thus oscillates, transferring into an oscillating voltage signal $V_m$.

The vibrations can thus be detected because of the distance changes. As the vibrations may be detected it is also possible to detect changes in the vibrational pattern. A typical subsea installation may consist of power electronic equipment like frequency converters, driving rotating machinery located not too far from the converters. Thus it is expected that electric equipment experiences certain vibrations, even with damped mounting.

Effects that are influencing the measurement signal and that may therefore be possible to measure are:

- changes in the external vibration, e.g. due to failures of adjacent subsea rotating machines
- decrease of the circuit board Eigen frequency, e.g. due to a part from inside the converter falling onto the circuit board and increasing its mass
- increase of the circuit board Eigen frequency, e.g. due to a part component of the circuit board getting loose/falling off and reducing the mass
- Shock, impact leading to oscillation peaks and damped recovery of original levels

Fig. 9A - E show variations of the measured voltage $V_m$ over time indicative of different conditions. These figures show a non-exhaustive overview of possible sensor signals.

Fig. 9A shows a reference measurement in normal operation. There is thus an oscillation due to normal fault-free operation. Furthermore, the voltage oscillates around zero, which indicates that the insulating medium is pure, i.e. free from impurities. Fig. 9B shows the same type of oscillation, however around a DC level unequal to zero. Fig. 9B thus indicates that there is a change in the permittivity of the insulating medium, and that the insulating medium is therefore polluted or degraded. Fig. 9C shows a measurement voltage with a higher amplitude than in fig. 9A, which may be due to machine failure. Fig. 9D shows a measured voltage with a lowered vibrational frequency than in fig. 9A, which may be due to a lowered Eigen frequency of the circuit board and fig. 9E shows a voltage with an amplitude that has an exponential decrease, which may be due to shock. The measured voltages $V_m$ in fig. 9C-E all oscillate around zero and thus indicate that the insulating medium is pure.

It should here be realized that the vibrations being detected may the external vibrations such as vibrations due to seismic activity outside the installation.

It can thus be seen that a number of different conditions are possible to detect with the device.

The measurement device also has a number of further advantages.

○ It is sensitive: pollution is possible to detect early at low levels

○ It is reliable: Measurements can be made over a long lifetime under subsea operation

○ It is flexible: It can be integrated at various positions in a power electronic circuit

Through a combined vibrational and pollution detection, several different conditions can thus be measured in a single arrangement with a limited number of components, which is both economical and also increases reliability. Since the measurement device is to be used in subsea applications, the number of components being used, i.e. the number of components that may fail, should be kept at a minimum and be of a simple structure. This is important since repair at subsea installations is obviously extremely hard to carry out.

The invention may therefore also be directed towards a method for detecting conditions of the electric or electronic subsea equipment provided in the enclosure with the insulating medium, which method is performed using the measurement device.

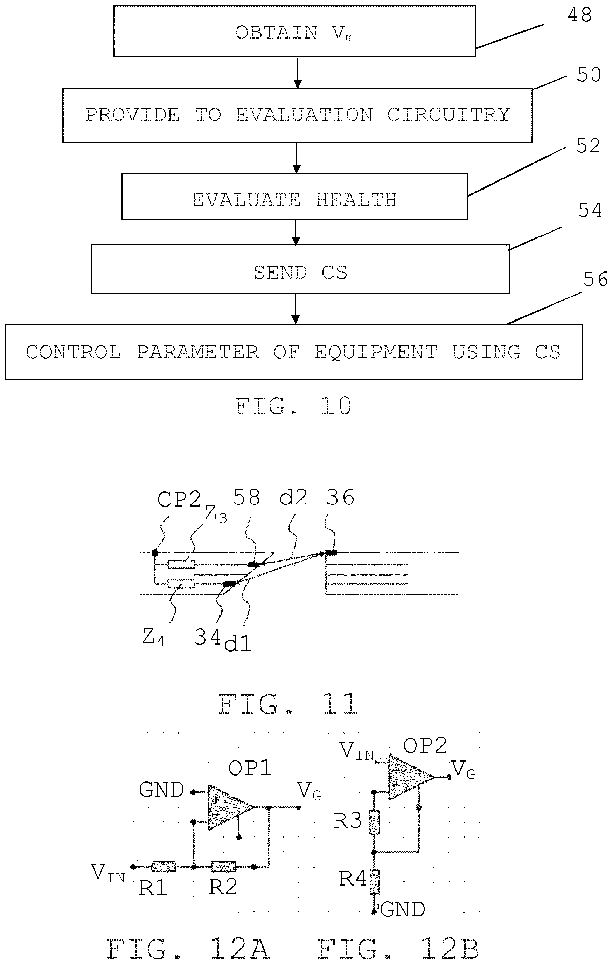

Fig. 10 shows a number of steps being performed in this method.

In the method the measurement device obtains the measurement signal $V_m$, step 48, where the measurement signal $V_m$ reflects impedance changes of the measurement impedance $Z_x$ formed by the capacitor electrodes. Optionally the signal also has vibrational content. The measurement signal $V_m$ is then provided to signal evaluation circuitry, step 50. The measurement signal is provided to such signal evaluation circuitry for evaluating the health of the electric or electronic subsea equipment.

The signal evaluation circuitry may be provided in the installation 14, for instance using a component mounted on the circuit board 26, such as a processor with associated program memory comprising signal evaluation software. As an alternative such signal evaluation circuitry may be provided outside the installation, for instance at the location 12 from where power is delivered to the installation 14. In this case it is possible that there is a communication channel between the measurement device and the signal evaluation circuitry, which channel may be provided in the cable via which power is delivered. Such a channel may be provided through a separate data communication channel. Alternatively it is possible to modulate the channel onto the electrical power delivered. In both cases suitable communication interfaces handling the practical aspects of the communication will of course be provided at both ends of the cable. It is also possible that signal conversion equipment such as A/D converters are employed.

The signal evaluation circuitry evaluates the health of the electric or electronic equipment using the measurement signal $V_m$, step 52. The evaluation of the health here furthermore comprises an evaluation of the dielectric properties of the insulating medium caused by impedance changes of the measurement impedance, which changes, as can be seen in fig. 9A and 9B, may be clearly identifiable in the signal $V_m$. Optionally the evaluation of the health also comprises evaluating changes in the vibrational content as outlined in fig. 9A, 9C, 9D and 9E. The evaluation may for instance involve comparing the measurement results to a predetermined value and setting or changing a parameter of the electric or electronic equipment, such as an operating parameter, as a result of the evaluation.

The signal evaluation circuitry may more particularly determine a control signal CS that acts on the above-mentioned parameter. The parameter may be such things as a phase angle, voltage level, output power level etc. that influences the operation of the equipment.

When the signal evaluation circuitry has determined such a control signal, it then sends the control signal CS to the equipment 22, step 54.

The control signal is then received in the enclosure 24, typically by a suitable local control unit in the equipment 22, and the parameter of the equipment 22 is then controlled using the control signal CS, step 56.

It can thereby be seen that the electric or electronic equipment is controlled based on the evaluation of the measurement signal. In this way it is possible to reduce or increase an operational aspect of the equipment that is influenced by the parameter. It is for instance possible to reduce power or perhaps completely shut down the equipment if the insulating medium is very polluted.

It is possible to expand on the measurement device. One example of this is shown in fig. 11, which shows a sectional view of a part of an alternative circuit board. In this variation there are two active branches. There is thus a second active branch with a series-connection of a second capacitive sensor made up of two capacitor electrodes forming a further measurement impedance in series with a fourth impedance $Z_4$. The second active branch is thus connected in parallel with the passive branch and the first active branch. Thereby it is possible to measure a measurement voltage between a midpoint of the second active branch and the midpoint of the passive branch. In the example in fig. 11, the first capacitor electrode 36 is common to both sensors. The first sensor is made up of the first and the second capacitor electrode 36 and 34, just as in the previous variation. The second sensor is made up of the first and a third capacitor electrode 36 and 58. In this example the second and third capacitor electrodes 34 and 58 are provided at different conductive layers of the circuit board. Thereby the third capacitor electrode 58 is vertically displaced from the corresponding capacitor electrode of the first active branch, i.e. from the second capacitor electrode 34, i.e. in a direction perpendicular to the upper board surface. In this example also the rim of the hole of the circuit board is beveled opposite of the projecting member 33. In the figure there is a first distance d1 between the first and second capacitor electrodes 34 and 36 and a second distance d2 between the first and the third capacitor electrodes 36 and 58. The realization in fig. 11 leads to two different situations that give rise to variations of the measured voltage. On the one hand the distances are different between the capacitor electrodes of the two sensors and on the other the sensing paths separated from each other. In the latter case it is for instance possible to detect a flow of an impurity in the insulating medium, in that one of the sensors experiences a change in the measurement voltage before the other. The speed of the flow may also be detected.

It should here be realized that it is possible to provide the capacitor electrodes of the two sensors with the same distances between each other, which is achieved if the rim is not beveled. It is in this case also possible with two completely separate sensors not sharing any capacitor electrodes.

- There are various options for the AC voltage feeding the measurement device. First, a quartz may be creating an oscillatory signal on the gate drive PCBAs, i.e. in gate control units used to drive electronics such as IGBTs. This signal could be amplified to improve the sensitivity of the sensor as sketched in Figure 12A.

An amplification circuit may thus be provided which obtains the above mentioned oscillatory signal as input $V_{in}$. This signal $V_{in}$ is provided to a negative input of an operational amplifier OP1 via a first resistor $R_1$, where the positive input of the amplifier OP1 is grounded. The output of the amplifier OP1 is connected to the negative input via a second resistor $R_2$ and the output also provides the signal $V_G$.

An alternative amplification circuit is shown in fig. 12B. In this case the signal $V_{in}$ is supplied to a positive input of an operational amplifier OP2, where the negative input of the amplifier OP2 is connected to ground via a third and a fourth resistor $R_3$ and $R_4$. The junction between these resistors $R_3$ and $R_4$ is connected to the power supply connection of the operational amplifier OP2. Also here the output of the amplifier OP2 provides the signal $V_G$.

The signal $V_{in}$ may thus be obtained from gate control units. Alternatively it may be obtained via DC-link capacitors of the AC/AC converter. These capacitors produce a relatively stable ripple voltage at already higher levels. The semiconductors also exhibit overshoots at switch-on and switch-off of up to several hundreds of volts. These could in principle also serve as signal $V_{in}$. Alternatively, the input signal $V_G$ can be provided by a signal generator, implemented as analog or as digital device.

- The concepts shown address the requirements for sensitivity, reliability, and flexible. Sensitivity is shown using equations and a realistic geometry of the device. Reliability is given especially for the basic concept (single Wheatstone bridge, no amplification) due to very low part count and the possibility to use reliable Surface Mounted Device (SMD) capacitors as impedances in the bridge. Flexibility is given since the sensor device can be driven with a variety of AC voltage signals found at different locations within an electric or electronic equipment 22 such as a frequency converter.

Another possible variation is that the measurement device may be able to compensate for temperature variations in the insulating medium. For this reason it may comprise means for compensating these temperature variations.

The means for compensating temperature variations may be implemented through a second measurement circuit comprising electrodes exposed to a reference insulating medium, which may be combined with the first measurement circuit in the following way:

The first measurement circuit is provided and operated in the previously described way. The second measurement circuit is as similar as possible to the first measurement circuit. It thus has a first, second, third and measurement impedance provided in the same way as the first measurement circuit. It may for instance have components of the same (production) batch as those used in the first measurement circuit (to reach similar thermal coefficients of the impedances). The first measurement circuit is exposed to the insulating medium which is exposed to aging (degradation, pollution, dissolved gas, etc.). The second measurement circuit is a reference measurement circuit. This circuit is exposed to an insulating medium (in a reference cell) which is not exposed to the above mentioned kind of aging. The reference insulating medium could be a different insulating medium with an appropriate temperature coefficient of impedance (similar to the sample insulating medium) or it could be the same insulating medium as for the first measurement circuit, however being shielded from aging agents/influences.

The key property of the reference insulating medium is that the dielectric properties remain stable over time and vary with temperature in the same way as the insulating medium under investigation. In operation the two Wheatstone-bridge measurement circuits may ideally be in close thermal contact.

The output signal from the measurement device is then determined from the reading of the first measurement circuit and from the reading of the second measurement circuit, e.g. by subtraction. If the reference insulating medium has the same or a very similar temperature coefficient of impedance as the insulating medium under investigation, the temperature error should be significantly reduced compared with the case of no temperature compensation.

The means for compensating temperature variations may as an alternative be implemented through a different configuration of the first measurement circuit. In this case one of the other impedances of the first measurement circuit is the means for compensating temperature variations. This compensating means or further impedance is then provided as electrodes exposed to a reference insulating medium.

The further impedance may then replace one of the previously described regular impedances of the first measurement circuit, such as the second impedance $Z_2$. This further impedance is then provided as a reference cell with reference insulating medium in which two capacitor electrodes are provided. If the temperature changes, the impedances of both insulating media (the medium under investigation and the reference medium) change in the same way (or in a predictable way) and the bridge output signal is not influenced by temperature. If the medium under investigation is aged, the reference medium is not, then there is a non-zero signal at the Wheatstone bridge output indicating the aging. This signal output is then independent from temperature influences.

To eliminate unwanted pressure effects, for both above-described variations of means for compensating temperature variations, there may be provided means for equalizing the pressure in the reference cell and in the sensing cell (e.g. bellows between the insulating medium chambers).

As yet another variation the means for compensating temperature variations may be provided as a temperature sensor and a measurement adjusting unit configured to adjust the measurement based on a temperature reading of the temperature sensor and a known temperature characteristic of the measurement device. The measurement adjusting unit may here be provided in the form of a suitably programmed processor.

The measurement adjusting unit in this case knows the temperature characteristic of the first measurement circuit (e.g., by a pre-calibration step) and stores data about the temperature dependency of the measurement voltage in a look-up table. Thereby it is able to compensate the measurement voltage reading if the temperature is known (by use of the temperature sensor and the look-up table from pre-calibration). From the foregoing discussion it is evident that the present invention can be varied in a multitude of ways. It shall consequently be realized that the present invention is only to be limited by the following claims.

**Claims**

1. A measurement device for electric or electronic equipment provided in an enclosure (24) with an insulating medium (IM), the measurement device comprising a first measurement circuit with a hole (28) to be filled with the insulating medium, and a first and a second opposed spaced apart capacitor electrode (36, 34) forming a measurement impedance ($Z_x$) for measuring changes in the dielectric properties of the insulating medium,
   **characterised in that**
   the measurement device is a measurement device for electric or electronic subsea equipment (22) and comprises a circuit board (26) with the hole (28) to be filled with the insulating medium.

2. The measurement device according to claim 1, where the electrodes are separated by a constant distance.

3. The measurement device according to claim 1 or 2, further comprising a first, second and third impedance ($Z_1$, $Z_2$, $Z_3$), wherein the first and the second impedance ($Z_1$, $Z_2$) are connected in series in a passive branch (PB) between a first and a second connection point (CP1, CP2) and the measurement and third impedance ($Z_x$, $Z_3$) are connected in series in a first active branch (AB1) in parallel with the passive branch, in order to receive a drive voltage ($V_G$) between the connection points and enable the measurement of a measurement voltage ($V_m$) between the midpoints of the passive and first active branch.

4. The measurement device according to any previous claim, further comprising a second active branch in parallel with the passive branch, the second active branch comprising capacitor electrodes (36, 58) forming a further measurement impedance in series with a fourth impedance ($Z_4$) for measuring a measurement voltage between the midpoints of the passive and second active branch.

5. The measurement device according to any previous claim, wherein at least one of the electrodes of the further measurement impedance of the second active branch at one side of the hole is displaced from a corresponding electrode of the measurement impedance of the first active branch at the same side of the hole.

6. The measurement device according to any previous claim, wherein the hole has an edge and further comprising a projecting member (33) projecting out from a part of the edge towards the center of the hole, where the first electrode (36) is provided on the projecting member and the second electrode (34) on a part of the edge opposite of the first electrode.

7. The measurement device according to claim 6, wherein the electric equipment (22) is configured to operate at an operational frequency and the projecting member is designed to resonate at at least one harmonic of this operational frequency.

8. The measurement device according to any previous claim, further comprising means for compensating temperature variations in the insulating medium.

9. The measurement device according to claim 8, wherein the means for compensating temperature variations comprises a second measurement circuit comprising electrodes exposed to a reference insulating medium.

10. The measurement device according to claim 8, wherein said first measurement circuit comprises a further impedance, where the means for compensating temperature variations forms said further impedance as electrodes exposed to a reference insulating medium.

11. The measurement device according to claim 8, wherein the means for compensating temperature variations comprises a temperature sensor and a measurement adjusting unit configured to adjust the measurement based on a temperature reading of the temperature sensor and a known temperature characteristic of the measurement device.

12. A subsea installation (14) comprising electric or electronic equipment (22) in an enclosure (24) filled with an insulating medium (IM), the subsea installation comprising a measurement device according to any of claims 1 - 11.

13. The subsea installation according to claim 12, wherein at least part of the electric equipment is mounted on the circuit board (26) of the measurement device.

14. A method for detecting conditions of electric or electronic equipment (22) provided in an enclosure (24) with an insulating medium (IM), the method being performed using a measurement device comprising a hole (28) filled with the insulating medium, the hole having a first and a second opposed spaced apart capacitor electrode (36, 34), the method comprising obtaining (48) a measurement signal ($V_m$) reflecting impedance changes of a measurement impedance ($Z_x$) formed by the capacitor electrodes (36, 34), and providing (50) the measurement signal ($v_m$) to signal evaluation circuitry for evaluating the health of the electric or electronic subsea equipment (22), where the evaluation of the health comprises an evaluation of the dielectric properties of the insulating medium caused by impedance changes,
**characterized in that**
the equipment is electric or electronic subsea equipment (22) and the measurement device comprises a circuit board (26) with the hole (28) to be filled with the insulating medium.

15. The method according to claim 14, wherein the hole has an edge and the circuit board further comprises a projecting member (33) projecting out from a part of the edge towards the center of the hole, where the first electrode (36) is provided on the projecting member and the second electrode (34) on a part of the edge opposite of the first electrode, where the obtained measurement signal has vibrational content and the evaluation of the health comprises evaluating changes in the vibrational content of the measurement signal.

**Patentansprüche**

1. Messvorrichtung für elektrische oder elektronische Ausrüstung, die in einem Gehäuse (24) mit einem Isoliermedium (IM) bereitgestellt ist, wobei die Messvorrichtung eine erste Messschaltung mit einer mit dem Isoliermedium zu füllenden Öffnung (28) und eine erste und eine zweite gegenüberliegende, beabstandete Kondensatorelektrode (36, 34) umfasst, die eine Messimpedanz ($Z_x$) zum Messen von Änderungen der dielektrischen Eigenschaften des Isoliermediums bilden, **dadurch gekennzeichnet, dass**
die Messvorrichtung eine Messvorrichtung für elektrische oder elektronische Unterwasserausrüstung (22) ist und eine Leiterplatte (26) mit der mit dem Isoliermedium zu füllenden Öffnung (28) umfasst.

2. Messvorrichtung nach Anspruch 1, wobei die Elektroden durch einen konstanten Abstand getrennt sind.

3. Messvorrichtung nach Anspruch 1 oder 2, ferner umfassend eine erste, zweite und dritte Impedanz ($Z_1$, $Z_2$, $Z_3$), wobei die erste und die zweite Impedanz ($Z_1$, $Z_2$) in einem passiven Zweig (PB) zwischen einem ersten und einem zweiten Verbindungspunkt (CP1, CP2) in Reihe verbunden sind und die Messimpedanz und die dritte Impedanz ($Z_x$, $Z_3$) in einem ersten aktiven Zweig (AB1) parallel zum passiven Zweig in Reihe verbunden sind, um eine Ansteuerungsspannung ($V_G$) zwischen den Verbindungspunkten zu empfangen und die Messung einer Messspannung ($V_m$) zwischen den Mittelpunkten des passiven und des ersten aktiven Zweigs zu ermöglichen.

4. Messvorrichtung nach einem der vorhergehenden Ansprüche, ferner umfassend einen zweiten aktiven Zweig parallel zum passiven Zweig, wobei der zweite aktive Zweig Kondensatorelektroden (36, 58) umfasst, die eine weitere Messimpedanz in Reihe mit einer vierten Impedanz ($Z_4$) zum Messen einer Messspannung zwischen den Mittelpunkten des passiven und des zweiten aktiven Zweigs bilden.

5. Messvorrichtung nach einem der vorhergehenden Ansprüche, wobei mindestens eine der Elektroden der weiteren Messimpedanz des zweiten aktiven Zweiges auf einer Seite der Öffnung von einer entsprechenden Elektrode der Messimpedanz des ersten aktiven Zweiges auf der gleichen Seite der Öffnung versetzt ist.

6. Messvorrichtung nach einem der vorhergehenden Ansprüche, wobei die Öffnung eine Kante aufweist und ferner ein vorstehendes Element (33) umfasst, das von einem Teil der Kante in Richtung der Mitte der Öffnung vorsteht, wobei die erste Elektrode (36) auf dem vorstehenden Element und die zweite Elektrode (34) auf einem Teil der Kante gegenüber der ersten Elektrode bereitgestellt ist.

7. Messvorrichtung nach Anspruch 6, wobei die elektrische Ausrüstung (22) dafür ausgelegt ist, mit einer Betriebsfrequenz betrieben zu werden, und das vorstehende Element dafür ausgelegt ist, mindestens auf einer Harmonischen dieser Betriebsfrequenz zu resonieren.

8. Messvorrichtung nach einem der vorhergehenden Ansprüche, ferner umfassend Mittel zum Kompensieren von Temperaturschwankungen im Isoliermedium.

9. Messvorrichtung nach Anspruch 8, wobei das Mittel zum Kompensieren von Temperaturschwankungen eine zweite Messschaltung umfasst, die Elektroden umfasst, die einem Referenzisoliermedium ausgesetzt sind.

10. Messvorrichtung nach Anspruch 8, wobei die erste Messschaltung eine weitere Impedanz umfasst, wobei das Mittel zum Kompensieren von Temperaturschwankungen die weitere Impedanz als Elektroden bildet, die einem Referenzisoliermedium ausgesetzt sind.

11. Messvorrichtung nach Anspruch 8, wobei das Mittel zum Kompensieren von Temperaturschwankungen einen Temperatursensor und eine Messeinstelleinheit umfasst, die dafür ausgelegt ist, die Messung basierend auf einer Temperaturmessung des Temperatursensors und einer bekannten Temperaturkennlinie der Messvorrichtung einzustellen.

12. Unterwasseranlage (14), umfassend elektrische oder elektronische Ausrüstung (22) in einem mit einem Isoliermedium (IM) gefüllten Gehäuse (24), wobei die Unterwasseranlage eine Messvorrichtung nach einem der Ansprüche 1-11 umfasst.

13. Unterwasseranlage nach Anspruch 12, wobei mindestens ein Teil der elektrischen Ausrüstung auf der Leiterplatte (26) der Messvorrichtung montiert ist.

14. Verfahren zum Erfassen von Bedingungen von elektrischer oder elektronischer Ausrüstung (22), die in einem Gehäuse (24) mit einem Isoliermedium (IM) bereitgestellt ist, wobei das Verfahren unter Verwendung einer Messvorrichtung durchgeführt wird, die eine mit dem Isoliermedium gefüllte Öffnung (28) umfasst, wobei die Öffnung eine erste und eine zweite gegenüberliegende, beabstandete Kondensatorelektrode (36, 34) aufweist, wobei das Verfahren Folgendes umfasst:

Erhalten (48) eines Messsignals ($V_m$), das Impedanzänderungen einer durch die Kondensatorelektroden (36, 34) gebildeten Messimpedanz ($Z_x$) widerspiegelt, und Bereitstellen (50) des Messsignals ($V_m$) für eine Signalauswertungsschaltung zum Bewerten des Zustands der elektrischen oder elektronischen Unterwasserausrüstung (22), wobei die Bewertung des Zustands eine Bewertung der dielektrischen Eigenschaften des Isoliermediums umfasst, die durch Impedanzänderungen verursacht werden,
**dadurch gekennzeichnet, dass**
die Ausrüstung eine elektrische oder elektronische Unterwasserausrüstung (22) ist und die Messvorrichtung eine Leiterplatte (26) mit der mit dem Isoliermedium zu füllenden Öffnung (28) umfasst.

15. Verfahren nach Anspruch 14, wobei die Öffnung eine Kante aufweist und die Leiterplatte ferner ein vorstehendes Element (33) umfasst, das von einem Teil der Kante in Richtung der Mitte der Öffnung vorsteht, wobei die erste Elektrode (36) auf dem vorstehenden Element und die zweite Elektrode (34) auf einem Teil der Kante gegenüber der ersten Elektrode bereitgestellt ist, wobei das erhaltene Messsignal einen Vibrationsgehalt aufweist und die Bewertung des Zustands das Bewerten von Änderungen im Vibrationsgehalt des Messsignals umfasst.


**Revendications**

1. Dispositif de mesure pour un équipement électrique ou électronique disposé dans une enceinte (24) avec un milieu isolant (IM), le dispositif de mesure comprenant un premier circuit de mesure avec un trou (28) devant être rempli avec le milieu isolant, et des première et deuxième électrodes de condensateur opposées espacées (36, 34) formant une impédance de mesure ($Z_x$) pour mesurer des changements dans les propriétés diélectriques du milieu isolant,

**caractérisé en ce que**

le dispositif de mesure est un dispositif de mesure pour un équipement électrique ou électronique sous-marin (22) et comprend une carte de circuit (26) avec le trou (28) devant être rempli avec le milieu isolant.

2. Dispositif de mesure selon la revendication 1, dans lequel les électrodes sont séparées par une distance constante.

3. Dispositif de mesure selon la revendication 1 ou 2, comprenant en outre des première, deuxième et troisième impédances ($Z_1$, $Z_2$, $Z_3$), les première et deuxième impédances ($Z_1$, $Z_2$) étant branchées en série dans une branche passive (PB) entre un premier et un deuxième point de branchement (CP1, CP2), et l'impédance de mesure et la troisième impédance ($Z_x$, $Z_3$) étant branchées en série dans une première branche active (AB1) en parallèle avec la branche passive, afin de recevoir une tension de commande ($V_G$) entre les points de branchement et permettre la mesure d'une tension de mesure ($V_m$) entre les milieux de la branche passive et de la première branche active.

4. Dispositif de mesure selon une quelconque revendication précédente, comprenant en outre une deuxième branche active en parallèle avec la branche passive, la deuxième branche active comprenant des électrodes de condensateur (36, 58) formant une autre impédance de mesure en série avec une quatrième impédance ($Z_4$) pour mesurer une tension de mesure entre les milieux de la branche passive et de la deuxième branche active.

5. Dispositif de mesure selon une quelconque revendication précédente, dans lequel au moins une des électrodes de l'autre impédance de mesure de la deuxième branche active d'un côté du trou est déplacée par rapport à une électrode correspondante de l'impédance de mesure de la première branche active du même côté du trou.

6. Dispositif de mesure selon une quelconque revendication précédente, dans lequel le trou a un bord, et comprenant en outre un élément en saillie (33) dépassant d'une partie du bord vers le centre du trou, la première électrode (36) étant disposée sur l'élément en saillie et la deuxième électrode (34) sur une partie du bord à l'opposé de la première électrode.

7. Dispositif de mesure selon la revendication 6, l'équipement électrique (22) étant configuré pour fonctionner à une fréquence de fonctionnement et l'élément en saillie étant conçu pour résonner à au moins une harmonique de cette fréquence de fonctionnement.

8. Dispositif de mesure selon une quelconque revendication précédente, comprenant en outre un moyen pour compenser des variations de température dans le milieu isolant.

9. Dispositif de mesure selon la revendication 8, dans lequel le moyen pour compenser des variations de température comprend un deuxième circuit de mesure comprenant des électrodes exposées à un milieu isolant de référence.

10. Dispositif de mesure selon la revendication 8, dans lequel ledit premier circuit de mesure comprend une autre impédance, le moyen pour compenser des variations de température formant ladite autre impédance sous la forme d'électrodes exposées à un milieu isolant de référence.

11. Dispositif de mesure selon la revendication 8, dans lequel le moyen pour compenser des variations de température comprend un capteur de température et une unité d'ajustement de mesure configurée pour ajuster la mesure sur la base d'une lecture de température du capteur de température et d'une caractéristique de température connue du dispositif de mesure.

12. Installation sous-marine (14) comprenant un équipement électrique ou électronique (22) dans une enceinte (24) remplie avec un milieu isolant (IM), l'installation sous-marine comprenant un dispositif de mesure selon l'une quelconque des revendications 1 à 11.

13. Installation sous-marine selon la revendication 12, dans laquelle au moins une partie de l'équipement électrique est montée sur la carte de circuit (26) du dispositif de mesure.

14. Procédé de détection de conditions d'un équipement électrique ou électronique (22) disposé dans une enceinte (24) avec un milieu isolant (IM), le procédé étant réalisé au moyen d'un dispositif de mesure comprenant un trou (28) rempli avec le milieu isolant, le trou ayant des première et deuxième électrodes de condensateur opposées espacées (36, 34), le procédé comprenant l'obtention (48) d'un signal de mesure ($V_m$) reflétant des changements d'impédance d'une impédance de mesure ($Z_x$) formée par les électrodes de condensateur (36, 34), et la délivrance (50) du signal de mesure ($V_m$) à un circuit d'évaluation de signal pour évaluer la santé de l'équipement électrique ou électronique sous-marin (22), l'évaluation de la santé comprenant une évaluation des propriétés diélectriques du milieu isolant induites par des changements d'impédance,

**caractérisé en ce que**

l'équipement est un équipement électrique ou électronique sous-marin (22) et le dispositif de mesure comprend une carte de circuit (26) avec le trou (28) devant être rempli avec le milieu isolant.

15. Procédé selon la revendication 14, dans lequel le trou a un bord et la carte de circuit comprend en outre un élément en saillie (33) dépassant d'une partie du bord vers le centre du trou, la première électrode (36) étant disposée sur l'élément en saillie et la deuxième électrode (34) sur une partie du bord à l'opposé de la première électrode, le signal de mesure obtenu ayant un contenu vibrationnel et l'évaluation de la santé comprenant l'évaluation de changements dans le contenu vibrationnel du signal de mesure.

12

16

14     18

20

FIG. 1

14

IM

22     24

AC/AC

FIG. 2

36  30    34
32        28
38              Z₃
              CP1
CP2         } AB1
         M2 M1
           } PB
26    33  Z₁    Z₂    FIG. 3

26

33

28

**FIG. 4**

33    28    34    $Z_3$
                M1

26  38    36    39

**FIG. 5**

$Z_X$

34

36    r    r

d

**FIG. 6**

M2

V$_G$

$Z_1$

$Z_x$

M1

V$_m$

$Z_2$

$Z_3$

44

42

FIG. 7

33

d(t) 34

36

O

FIG. 8

V$_m$

t

V$_m$

t

FIG. 9A

FIG. 9B

V$_m$

t

V$_m$

t

V$_m$

t

FIG. 9C

FIG. 9D

FIG. 9E

OBTAIN $V_m$ — 48

PROVIDE TO EVALUATION CIRCUITRY — 50

EVALUATE HEALTH — 52

SEND CS — 54

CONTROL PARAMETER OF EQUIPMENT USING CS — 56

FIG. 10

FIG. 11

FIG. 12A    FIG. 12B

**EP 3 077 835 B1**

**Patent documents cited in the description**

- US 20070227880 A
- US 20110018733 A